(19) Europäisches Patentamt

European Patent Office

Office européen des brevets

(11) **EP 1 992 956 A1**

(12) **EUROPEAN PATENT APPLICATION**

(43) Date of publication:
**19.11.2008 Bulletin 2008/47**

(51) Int Cl.:
***G01R 33/16*** (2006.01)

(21) Application number: **07251989.5**

(22) Date of filing: **15.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **INDUSTRIAL TECHNOLOGY RESEARCH INSTITUTE**
**Chutung,**
**Hsinchu (TW)**

(72) Inventors:
• **Pan, Sheau-Shi**
**East District, Hsinchu City 300 (TW)**
• **Chang, Chi-Sheng**
**Jhongli City,**
**Taoyuan County 320 (TW)**
• **Lin, Yi-Ching**
**East District, Hsinchu City 300 (TW)**

(74) Representative: **Johnson, Terence Leslie**
**Marks & Clerk**
**90 Long Acre**
**London**
**WC2E 9RA (GB)**

Remarks:
Amended claims in accordance with Rule 137(2) EPC.

(54) **Device and method for measuring magnetic properties of metal material**

(57) A device (100) and method for measuring magnetic properties of a metal material (130) is provided. The device (100) has a magnet (124), a scale (120), a hanger (110), and a distance meter (140). The magnet (124) is set on the scale (120), and the scale is used to read a reading of a magnetic interaction force. The hanger (110) is movably arranged above the scale (120) for carrying the metal material, and capable of moving up and/or down due to the magnetic interaction force, so that a relative distance (Zo) exists between the magnet (124) and the metal material (130). The distance meter (140) is used to measure the relative distance (Zo). A magnetic property value can be calculated from the relative distance and the magnetic interaction force.

FIG. 1

**Description**

BACKGROUND OF THE INVENTION

Field of the Invention

The present invention relates to a device and a method for measuring magnetic properties. More particularly, the present invention relates to a device and a method for measuring the magnetic properties of a metal material.

Description of Related Art

Usually, magnetic properties of a metal object under measurement are generally deduced from the reading variation of a scale, thus achieving the measurement of data of the magnetic properties of a metal material. Currently, a weight serving as a reference sample must be used and the measurement must be performed in a fixed distance. Herein, the distance refers to the distance between the object under measurement and a magnet.
The conventional art adopts fixed points, so measurements are made at each single point every time. Therefore, the magnetic properties of the metal object under measurement cannot be measured over a continuous distance. Furthermore, in the conventional art, the object under measurement cannot be measured until it is calibrated against a standard weight. Therefore, the magnetic properties of the object under measurement cannot be measured directly, thereby degrading the precision of the conventional art.
Our invention provides method and device for directly measuring the object under measurement without using the standard weight. Furthermore, a continuous multi-point measurement method and device are also needed.

SUMMARY OF THE INVENTION

In view of the aforementioned problems, the present invention seeks to provide a device for measuring magnetic properties of a metal material. The device comprises a magnet for generating a magnetic field, a scale, a hanger, and a distance meter. The magnet is set on the scale, so as to measure a magnetic interaction force between the magnet and the metal material. The hanger is movably arranged above the scale for carrying the metal material. The hanger can be moved up and/or down due to the magnetic interaction force, so that a relative distance exists between the magnet and the metal material. The distance meter is used to measure the relative distance. A magnetic property value of the metal material can be calculated from the magnetic interaction force and the relative distance, thereby obtaining the magnetic properties of the metal material.
Furthermore, the present invention also seeks to provide a device for measuring magnetic properties, so as to measure the magnetic property value of a magnet. The device includes a magnet, a scale, a hanger, and a distance meter. The magnet is used to generate a magnetic field. The magnet is set on the scale, and the scale is used to measure a magnetic interaction force between the magnet and a reference metal material. The hanger is movably arranged above the scale for carrying the reference metal material. The hanger can be moved up and/or down due to the magnetic interaction force, so that a relative distance exists between the magnet and the reference metal material. The distance meter is disposed at a position where the relative distance can be measured. A magnetic property value of the magnet is calculated from the magnetic interaction force and the relative distance. The magnetic property value is, for example, a magnetic moment, a magnetic force, or a magnetic force variation, etc.
Additionally, the present invention also seeks to provide a method for measuring the magnetic properties of a metal material. Firstly, the material metal is placed on a movable hanger, and a magnet is placed on a scale. In this way, a magnetic interaction is generated between metal material and the magnet, so as to move the hanger up and/or down. Next, under the balance of the magnetic interaction, a reading of the scale is read and the relative distance between the metal material and the magnet is measured. After that, a magnetic property value of the metal material is calculated from the relative distance and the reading of the scale.
With the aforementioned architecture and method of the present invention, the distance between the magnet the metal material under measurement can be measured, thereby reducing the measurement time and increasing the flexibility of measurement.
In order to the make aforementioned and other objects, features and advantages of the present invention comprehensible, embodiments accompanied with figures are described in detail below.
It is to be understood that both the foregoing general description and the following detailed description are exemplary, and are intended to provide further explanation of the invention as claimed.

BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a schematic diagram of the device for measuring the magnetic properties of a metal material according to the present invention.

FIG. 2 is a schematic diagram showing a flow chart of the measuring method according to the present invention.

FIG. 3 is a schematic diagram of the continuous measurements for the value $\chi$ of a sample Alacrite™.

FIG. 4 is a schematic diagram of the measurement of the value $\chi$ of the sample Alacrite™ at each point.

FIG. 5 is a schematic diagram of the continuous measurement for the value $\chi$ of a sample CHYO4™.

FIG. 6 is a schematic diagram of the measurement of the value $\chi$ of the sample CHYO4™ at each point.

DESCRIPTION OF EMBODIMENTS

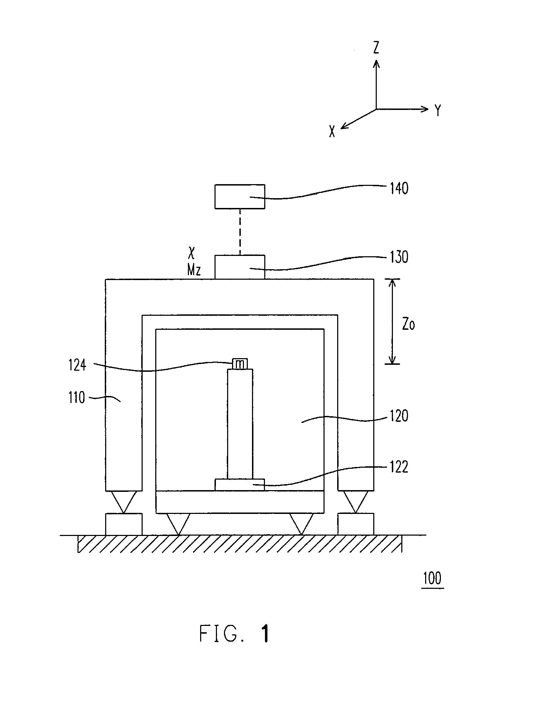

FIG. 1 is a schematic diagram of the device for measuring the magnetic properties of a metal material according to the present invention. As shown in FIG. 1, in this embodiment, the device 100 for measuring magnetic properties is used to measure the magnetic properties of a metal material 130 and comprises a magnet 124, a scale 120, a hanger 110, and a distance meter 140. The magnet 124 is used to generate a magnetic field. The magnet 124 is set on the scale 120, and the scale 120 is used to measure a magnetic interaction force between the magnet 124 and the metal material 130. The hanger 110 is movably arranged above the scale 120 for carrying the metal material 130. The hanger 110 can be moved up and down due to the magnetic interaction force, such that a relative distance $Z_0$ exists between the magnet 124 and the metal material 130. The distance meter 140 is disposed at a position where the relative distance $Z_0$ can be measured. A magnetic property value of the metal material 130 is thus calculated by the device 100 from the magnetic interaction force and the relative distance $Z_0$, so as to obtain the magnetic properties of the metal material 130.

Under the action of the magnetic force between the magnet 124 and the object 130 under measurement, the hanger 110 is moved up and down along the Z direction of the device 100 for measuring magnetic properties. Therefore, the height of the hanger 110 can be adjusted.

In consideration of the measurement of magnetic properties, the material of the hanger 110 is preferably a material whose magnetic susceptibility (i.e., the value $\chi$) is as low as possible, so as to not affect the accuracy of the measurement of magnetic properties. Generally speaking, the material is, for example, high-grade stainless steel, i.e., stainless steel with minimum dopants, and aluminum is the preferred material. For convenience, the movable hanger 110 is referred to an aluminum bridge 110 in the following description.

Referring to FIG. 1, the method of operating the device 100 for measuring magnetic properties is illustrated. As shown in FIG. 1, during the measurement, the magnet 124 is set on the scale 120, for example, a scale pan 122 carries the magnet 124. The magnet 124 has a magnetic moment m, which can generate a magnetic field H in the device 100 for measuring magnetic properties. Thus, due to the magnetic field H, a magnetic interaction is generated between the magnet 124 and the metal material 130 under measurement.

The scale 120 can be an ordinary scale used to measure the mass of an object. Herein, the scale 120 is used to measure the force generated by the magnetic interaction. The reading of the scale 120 varies due to the action of the magnetic force between the magnet 124 and the metal material 130 and the attractive force and the repulsive force generated by gravity. The reading read by the scale 120 is expressed by the following formulas.

$$F = -\frac{\mu_0}{2}\frac{\partial}{\partial z}\iiint_V \chi\vec{H}\cdot\vec{H}dV - [\mu_0\frac{\partial}{\partial z}\iiint_v [M_z + \chi H_E]\cdot f\{\rho, z\}dV](m)$$

$$= \chi F_{H^2} + \mu_0[M_z + \chi H_E]F_{H_z}(m)$$

$$\vec{H}\cdot\vec{H} = \vec{H}_d\cdot\vec{H}_d + 2\vec{H}_d\cdot\vec{H}_Q + \vec{H}_Q\cdot\vec{H}_Q$$

$$\vec{H}_d \cdot \vec{H}_d = \frac{m^2}{16\pi^2} \frac{[\rho^2 + 4z^2]}{[\rho^2 + z^2]^4}$$

$$\vec{H}_d \cdot \vec{H}_Q = -\frac{m^2 z_m}{32\pi^2} \frac{[2k_m\rho^3 + 10k_m\rho^2 z + 12z^3]}{[\rho^2 + z^2]^5}$$

$$\vec{H}_Q \cdot \vec{H}_Q = \frac{m^2 z_m^2}{64\pi^2} \frac{[9(\rho^4 + z^4) - 12k_m\rho z(\rho^2 - 4z^2) + 4k_m^2(\rho^4 + 7\rho^2 z^2 + 12z^4)]}{[\rho^2 + z^2]^6}$$

$$H_Z = H_{dZ} + H_{QZ} = [\frac{(\rho^2 - 4z^2)}{4\pi[\rho^2 + z^2]^{5/2}} + \frac{[-9\rho^2 z + 6z^3 + k_m(8\rho z^2 - 2z^3)]}{8\pi[\rho^2 + z^2]^{7/2}} \cdot z_m](m)$$

$$F = -\frac{\mu_0}{2} \frac{\partial}{\partial z} \iiint_V \chi \vec{H} \cdot \vec{H} dV - [\mu_0 \frac{\partial}{\partial z} \iiint_v [M_Z + \chi H_E] \cdot f\{\rho, z\} dV](m)$$

$$= \chi F_{H^2} + \mu_0[M_Z + \chi H_E] F_{H_Z}(m)$$

where $\chi$ stands for the magnetic susceptibility, m stands for the magnetic moment of the magnet 124, Mz stands for the permanent magnetization of the metal material 130, and Hz stands for an Earth's magnetic field. The magnetic moment can be a dipole moment or second-order expansion magnetic moment (a quadrupole moment), and the magnetic force is obtained by expanding a first-order magnetic moment and a second-order expansion magnetic moment (a quadrupole moment).

Furthermore, $Z_0$ in formula (1) stands for the distance between the metal material 130 and the magnet 124. As described above, the aluminum bridge 110 spans over the scale 120, and can be moved up and down along the Z direction. Under the action of the magnetic force between the magnet 124 and the metal material 130, the attractive force and the repulsive force generated by magnetic force, the aluminum bridge 110 is moved up or down, and then reaches a balance state. At this time, the relative distance $Z_0$ between the magnet 124 and the metal material 130 can be measured by using the distance meter 140.

The distance meter 140 can be constructed from an interferometer, for example, a 3-axis compact interferometer. With the distance meter 140 in the present invention, the relative distance $Z_0$ can be measured easily and precisely. Therefore, it solves the problem in the conventional art that the measurement must be performed only at a fixed distance.

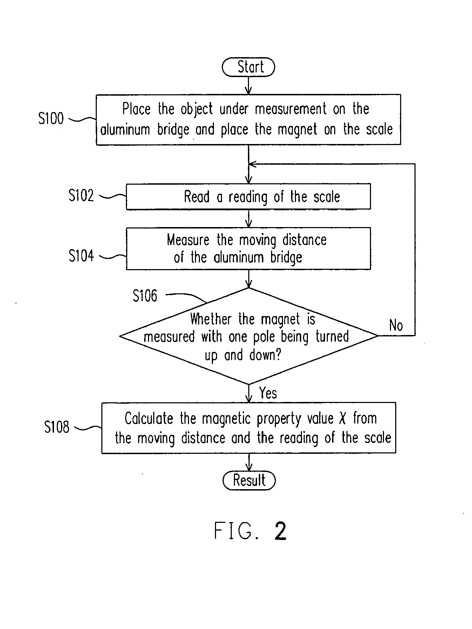

FIG. 2 is a schematic diagram of a flow chart of the measuring method according to the present invention. As shown in FIGs. 1 and 2, firstly, in Step S100, the metal material 130 under measurement is placed on the aluminum bridge 110, and the magnet 124 is set on the scale 120. The aluminum bridge 100 is moved under the magnetic field created by the magnet between the metal material 130 and the magnet 124.

In steps S102 and S104, under the balance of the magnetic interaction, the reading of the scale 120 is read and the relative distance $Z_0$ between the metal material 130 and the magnet 124 is measured. The reading step and the measuring step are performed without an exact sequence.

After that, in step S106, it is determined whether one of the poles of the magnet 124 is measured respectively in the up and down directions. If it does, in Step S108, a magnetic property value such as the magnetic susceptibility, i.e., the value $\chi$ of the metal material 130 is calculated from the reading of the scale and the measured moving distance $Z_0$. Turning the magnetic pole (such as the south pole or the north pole) up or down can vary the direction of the magnetic moment of the magnet 124. As a result, the permanent magnetization $M_Z$ of the metal material 130 in formula (1) can be eliminated. Otherwise, i.e., the magnetic pole is not turned around, the magnetic pole of the magnet 124 is turned around, and then Steps S 102 and S 104 is performed repeatedly.

In Step S108, the magnetic property value of the metal material 130, such as the magnetic susceptibility value $\chi$, can be calculated from the reading and the measured relative distance according to the formula (1).

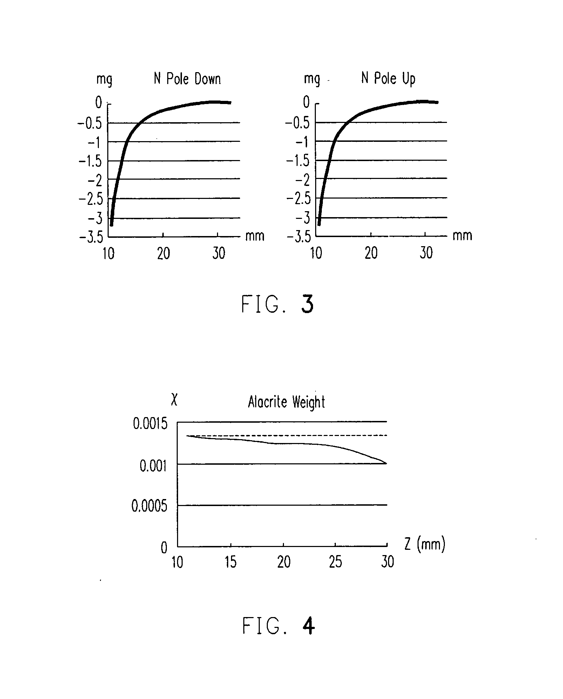

FIG. 3 is a schematic diagram showing the continuous measurement for the value $\chi$ of a sample Alacrite™. FIG. 4 is a schematic diagram of the measurement of the value $\chi$ of the sample Alacrite™ at each point. Herein, the standard weight Alacrite™ serves as the metal material under measurement, so as to illustrate the feasibility of the device and the method for measuring magnetic properties of this embodiment. FIG. 3 shows the relationship between the value $\chi$ of the weight Alacrite™ and the distance $Z_0$ when the north pole of the magnet is turned up and down respectively. Furthermore, FIG. 4 shows the results of the measurement of the value $\chi$ of the standard weight Alacrite™ over a distance Z at each point by using the above measuring method and device. It can be seen from the results that the value $\chi$ is consistent with a standard value. Therefore, it is confirmed that the method and the device are actually feasible.

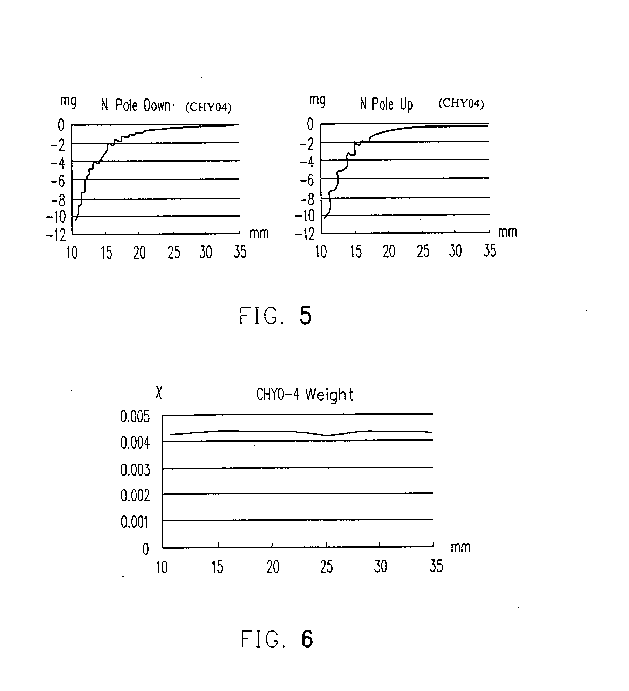

Additionally, in this embodiment, a standard weight CHYO4™ is also used to do the same experiment, and the results are shown in FIGs. 5 and 6, respectively. Similarly, FIG. 5 is a schematic diagram of the continuous measurement for the value $\chi$ of the sample CHYO4™, which shows the results of the measurement of the value $\chi$ of the standard weight CHYO4™ at each point Z in the cases of north pole up and down. FIG 6 is a schematic diagram of the measurement of the value $\chi$ of the sample CHYO4™ at each point. Likewise, it can be seen from the results that the value $\chi$ is consistent with a standard value. Therefore, it can be confirmed that the method and the device are actually feasible.

In the aforementioned embodiment, the magnetic property value of the metal under measurement is measured, but the present invention is not limited to this. By replacing the metal under measurement with a reference metal material, such as a standard weight for reference, the magnetic properties of the reference metal material are already known, so the device for measuring magnetic properties in the aforementioned embodiment can be used to measure the magnetic moment, the magnetic force, or the magnetic force variation of the magnet. The magnetic moment, the magnetic force, or the magnetic force variation can be determined from the relative distance between the magnet and the reference metal material, i.e., is determined from the aforementioned moving distance $Z_0$.

In view of the above description, with the aforementioned architecture and method, the present invention can be used to measure the distance between the magnet and the metal material under measurement, reduce the measurement time, and improve the flexibility of measurement.

Furthermore, in this embodiment, the distance $Z_0$ can be directly measured by using the action of the magnetic force between the magnet and the object under measurement without using a standard weight. Therefore, the distance $Z_0$ can ensure a high precision of the data of measurement. In addition, in this embodiment, the analysis is performed by using the dipole moment and the second-order dipole moment, thus the present invention is more precise than the conventional art.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

**Claims**

1. A device for measuring magnetic properties of a metal material, comprising:

   a magnet, for generating a magnetic field;
   a scale, on which the magnet is set, for measuring a magnetic interaction force between the magnet and the metal material;
   a hanger, movably arranged above the scale for carrying the metal material, and capable of moving up and/or down due to the magnetic interaction force, so that a relative distance exists between the magnet and the metal material; and
   a distance meter, arranged at a position to measure the relative distance,

   wherein a magnetic property value of the metal material is calculated from the magnetic interaction force and the relative distance.

2. A device as claimed in claim 1, wherein the material of the hanger is aluminum.

3. A device as claimed in claim 1 or claim 2, wherein the distance meter is an interferometer.

**4.** A device as claimed in any preceding claim, wherein the magnetic property value is a magnetic susceptibility.

**5.** A device for measuring magnetic properties, for measuring a magnetic property value of a magnet, comprising:

a magnet, for generating a magnetic field;
a scale, on which the magnet is set, for measuring a magnetic interaction force between the magnet and a reference metal material;
a hanger, movably arranged above the scale for carrying the reference metal material, and capable of moving up and/or down due to the magnetic interaction force, such that a relative distance exists between the magnet and the reference metal material; and
a distance meter, disposed at a position to measure the relative distance,

wherein the magnetic property value of the magnet is calculated from the magnetic interaction force and the relative distance.

**6.** A device as claimed in claim 5, wherein the material of the hanger is aluminum.

**7.** A device as claimed in claim 5 or claim 6, wherein the distance meter is an interferometer.

**8.** A device as claimed in any of claims 5 to 7, wherein the magnetic property value is a magnetic moment of the magnet.

**9.** A device as claimed in claim 8, wherein the magnitude of the magnetic moment is determined by the relative distance.

**10.** A device as claimed in claim 9, wherein the magnetic moment is a dipole moment, and the magnetic force is obtained by expanding a first-order magnetic moment and a second-order magnetic moment.

**11.** A device as claimed in claim 9, wherein the magnetic moment is a quadrupole moment.

**12.** A device as claimed in any of claims 5 to 7, wherein the magnetic property value is a magnetic force of the magnet.

**13.** A device as claimed in claim 12, wherein the magnitude of the magnetic force is determined by the relative distance.

**14.** A device as claimed in any of claims 5 to 7, wherein the magnetic property value is a magnetic force variation of the magnet.

**15.** A device as claimed in claim 14, wherein the magnitude of the magnetic force variation is determined by the relative distance.

**16.** A method of measuring magnetic properties of a metal material, comprising:

placing a metal material on a hanger, and placing a magnet on a scale, wherein the metal material and the magnet produce a magnetic interaction, so as to move the hanger up and/or down;
reading a reading of the scale under the balance of the magnetic interaction, and measuring a relative distance between the metal material and the magnet; and
calculating a magnetic property value of the metal material from the relative distance and the reading of the scale.

**17.** A method as claimed in claim 16, further comprising:

turning one of the magnetic poles of the magnet up and down respectively, so as to measure the relative distance.

**18.** A method as claimed in claim 16 or claim 17, further comprising:

measuring the relative distance by using an interferometer.

**19.** A method as claimed in any of claims 16 to 18, wherein the magnetic property value is a magnetic susceptibility.

**20.** A method of measuring magnetic properties, comprising:

placing a reference metal material on a hanger and placing a magnet on a scale, wherein the reference metal material and the magnet produce a magnetic interaction, so as to move the hanger up and/or down;
reading a reading of the scale under the balance of the magnetic interaction, and measuring a relative distance between the metal material and the magnet; and
calculating a magnetic property value of the magnet from the relative distance and the reading of the scale.

21. A method as claimed in claim 20, further comprising:

turning one of the magnetic poles of the magnet up and down respectively, so as to measure the relative distance.

22. A method as claimed in claim 20, further comprising:

measuring the relative distance by using an interferometer.

23. A method as claimed in any of claims 20 to 22, wherein the magnetic property value is a magnetic moment, a magnetic force, or a magnetic force variation of the magnet.

24. A method as claimed in claim 23, wherein the magnitude of the magnetic moment, the magnetic force, or the magnetic force variation is determined by a predetermined distance.

25. A method as claimed in claim 23 or claim 24, wherein the magnetic moment is a dipole moment, and the magnetic force is obtained by expanding a first-order magnetic moment and a second-order magnetic moment.

26. A method as claimed in claim 23 or claim 24, wherein the magnetic moment is a quadrupole moment.

**Amended claims in accordance with Rule 137(2) EPC.**

**1.** A device (100) for measuring magnetic properties of a metal material (130), comprising:

a magnet (124), for generating a magnetic field;
a scale (120), on which the magnet is set, for measuring a magnetic interaction force between the magnet and the metal material;
a hanger (110), movably arranged above the scale for carrying the metal material, and capable of moving up and/or down due to the magnetic interaction force, so that a relative distance ($Z_o$) exists between the magnet and the metal material; and
a distance meter (140), arranged at a position to measure the relative distance,
wherein a magnetic property value of the metal material is calculated from the magnetic interaction force and the relative distance.

**2.** A device as claimed in claim 1, wherein the material of the hanger is aluminum.

**3.** A device as claimed in claim 1 or claim 2, wherein the distance meter is an interferometer.

**4.** A device as claimed in any preceding claim, wherein the magnetic property value is a magnetic susceptibility ($\chi$).

**5.** A device (100), for measuring a magnetic property value of a magnet (124), comprising:

a magnet, for generating a magnetic field;
a scale (120), on which the magnet is set, for measuring a magnetic interaction force between the magnet and a reference metal material (130);
a hanger (110), movably arranged above the scale for carrying the reference metal material, and capable of moving up and/or down due to the magnetic interaction force, such that a relative distance ($Z_o$) exists between the magnet and the reference metal material; and
a distance meter (140), disposed at a position to measure the relative distance,
wherein the magnetic property value of the magnet is calculated from the magnetic interaction force and the relative distance.

**6.** A device as claimed in claim 5, wherein the material of the hanger is aluminum.

**7.** A device as claimed in claim 5 or claim 6, wherein the distance meter is an interferometer.

**8.** A device as claimed in any of claims 5 to 7, wherein the magnetic property value is the magnetic moment of the magnet.

**9.** A device as claimed in claim 8, wherein the magnetic moment is a dipole moment, and the magnetic force is obtained by expanding a first-order magnetic moment and a second-order magnetic moment.

**10.** A device as claimed in claim 8, wherein the magnetic moment is a quadrupole moment.

**11.** A device as claimed in any of claims 5 to 7, wherein the magnetic property value is a magnetic force of the magnet.

**12.** A device as claimed in any of claims 5 to 7, wherein the magnetic property value is a magnetic force variation of the magnet.

**13.** A method of measuring magnetic properties of a metal material, comprising:

placing a metal material on a hanger (S100), and placing a magnet on a scale (S100), wherein the metal material and the magnet produce a magnetic interaction, so as to move the hanger up and/or down;
reading a reading of the scale (S102) under the balance of the magnetic interaction, and measuring a relative distance (S104) between the metal material and the magnet; and
calculating a magnetic property value (S108) of the metal material from the relative distance and the reading of the scale.

**14.** A method as claimed in claim 13, further comprising:

turning one of the magnetic poles of the magnet up and down respectively (S106), so as to measure the relative distance.

**15.** A method as claimed in claim 13 or claim 14, further comprising:

measuring the relative distance by using an interferometer.

**16.** A method as claimed in any of claims 13 to 15, wherein the magnetic property value is a magnetic susceptibility ($\chi$).

**17.** A method of measuring magnetic properties, comprising:

placing a reference metal material on a hanger (S100) and placing a magnet on a scale (S100), wherein the reference metal material and the magnet produce a magnetic interaction, so as to move the hanger up and/or down;
reading a reading of the scale (S102) under the balance of the magnetic interaction, and measuring a relative distance (S104) between the metal material and the magnet; and
calculating a magnetic property value of the magnet (S108) from the relative distance and the reading of the scale.

**18.** A method as claimed in claim 17, further comprising:

turning one of the magnetic poles of the magnet up and down respectively (S106), so as to measure the relative distance.

**19.** A method as claimed in claim 17, further comprising:

measuring the relative distance by using an interferometer.

**20.** A method as claimed in any of claims 17 to 19, wherein the magnetic property value is a magnetic moment, a magnetic force, or a magnetic force variation of the magnet.

**21.** A method as claimed in claim 20 or claim 21, wherein the magnetic moment is a dipole moment, and the magnetic force is obtained by expanding a first-order magnetic moment and a second-order magnetic moment.

**22.** A method as claimed in claim 20 or claim 21, wherein the magnetic moment is a quadrupole moment.

Z

Y

X

χ
Mz

140

130

Zo

124

110

120

122

100

FIG. 1

```
                          ( Start )
                             │
                             ▼
         ┌──────────────────────────────────────────┐
S100 ──  │ Place the object under measurement on the │
         │ aluminum bridge and place the magnet on the scale │
         └──────────────────────────────────────────┘
                             │
                             ▼  ◄─────────────────────┐
         ┌──────────────────────────────────────────┐ │
S102 ──  │        Read a reading of the scale        │ │
         └──────────────────────────────────────────┘ │
                             │                         │
                             ▼                         │
         ┌──────────────────────────────────────────┐ │
         │        Measure the moving distance        │ │
S104 ──  │          of the aluminum bridge           │ │
         └──────────────────────────────────────────┘ │
                             │                         │
      S106 ──┐               ▼                         │
              ◄──────────────────────────►  No         │
         ╱   Whether the magnet is       ╲ ───────────┘
        ◄   measured with one pole being turned  ►
         ╲        up and down?          ╱
              ◄──────────────────────────►
                             │ Yes
                             ▼
         ┌──────────────────────────────────────────┐
S108 ──  │ Calculate the magnetic property value X from │
         │ the moving distance and the reading of the scale │
         └──────────────────────────────────────────┘
                             │
                             ▼
                        ( Result )
```

FIG. 2

mg   N Pole Down

| | |
|---|---|
| 0 | |
| −0.5 | |
| −1 | |
| −1.5 | |
| −2 | |
| −2.5 | |
| −3 | |
| −3.5 | mm |
| 10    20    30 | |

mg   N Pole Up

| | |
|---|---|
| 0 | |
| −0.5 | |
| −1 | |
| −1.5 | |
| −2 | |
| −2.5 | |
| −3 | |
| −3.5 | mm |
| 10    20    30 | |

FIG. 3

$\chi$   Alacrite Weight

0.0015

0.001

0.0005

0

10   15   20   25   30   Z (mm)

FIG. 4

FIG. 5

FIG. 6

**European Patent Office**

## EUROPEAN SEARCH REPORT

Application Number

EP 07 25 1989

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 514 759 A (SEIKO INSTR CO LTD [JP] SEIKO INSTR CO LTD [DE] SEIKO INSTR INC [JP]) 25 November 1992 (1992-11-25) * the whole document * | 1-26 | INV. G01R33/16 |
| A | DAVIS R S ET AL: "New method to measure magnetic susceptibility" MEASUREMENT SCIENCE AND TECHNOLOGY, INSTITUTE OF PHYSICS PUBLISHING, BRISTOL, GB, vol. 4, no. 2, 1 February 1993 (1993-02-01), pages 141-147, XP020065382 ISSN: 0957-0233 * figure 3 * | 1-26 | |
| A | KITA E ET AL: "IN SITU SUSCEPTIBILITY MEASUREMENT OF THE LOW TEMPERATURE MARTENSITIC TRANSFORMATION" IEEE TRANSLATION JOURNAL ON MAGNETICS IN JAPAN, IEEE INC, NEW YORK, US, vol. 8, no. 2, 1 February 1993 (1993-02-01), pages 112-117, XP000355475 ISSN: 0882-4959 * abstract; figures 1-5 * | 1-26 | TECHNICAL FIELDS SEARCHED (IPC) G01R |
| A | HILL G J ET AL: "The influence of positioning errors on susceptibility measurement by the Faraday method" JOURNAL OF PHYSICS E. SCIENTIFIC INSTRUMENTS, INSTITUTE OF PHYSICS PUBLISHING, BRISTOL, GB, vol. 1, no. 1, 1 January 1968 (1968-01-01), pages 52-54, XP020017998 ISSN: 0022-3735 * page 52, left-hand column, lines 1-22; figures 1,3 * | 1-26 | |

The present search report has been drawn up for all claims

| Place of search | Date of completion of the search | Examiner |
|---|---|---|
| Munich | 29 November 2007 | Dogueri, Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 25 1989

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2007

| Patent document cited in search report | | Publication date | Patent family member(s) | | Publication date |
|---|---|---|---|---|---|
| EP 0514759 | A | 25-11-1992 | DE | 69226473 D1 | 10-09-1998 |
| | | | DE | 69226473 T2 | 07-01-1999 |
| | | | JP | 2764102 B2 | 11-06-1998 |
| | | | JP | 4346087 A | 01-12-1992 |
| | | | US | 5252920 A | 12-10-1993 |

EPO FORM P0459

For more details about this annex : see Official Journal of the European Patent Office, No. 12/82